# EUROPEAN PATENT APPLICATION

(11) **EP 2 728 636 A1**
(43) Date of publication of application: **07.05.2014**
(21) Application number: 11868636.9
(22) Date of filing: 30.06.2011
(51) Int. Cl.: H01L 51/50, H01L 51/52, H01L 51/54

(54) **TOP-EMITTING FLEXIBLE ORGANIC LIGHT EMISSION DIODE DEVICE AND PREPARATION METHOD THEREOF**

(71) Applicant: Ocean's King Lighting Science&Technology Co., Ltd., Shenzhen, Guangdong 518054 (CN)
(72) Inventor: ZHOU, Mingjie, Shenzhen Guangdong 518054 (CN); WANG, Ping, Shenzhen Guangdong 518054 (CN); FENG, Xiaoming, Shenzhen Guangdong 518054 (CN); HUANG, Hui, Shenzhen Guangdong 518054 (CN)
(74) Representative: Lenthall, Joseph
(86) International application number: PCT/CN2011/076708
(87) International publication number: WO 2013/000163

(57) **Abstract**

A top-emitting flexible organic light emission diode device and preparation method thereof are provided. The device involves overlapping a substrate, an anode layer, a hole injection layer, a hole transport layer, an emission layer, an electron transport layer, an electron injection layer and a cathode layer sequentially. The material of the cathode is scythe-silver alloy or ytterbium-silver alloy. The method for preparing the device comprises the following steps: cleaning and drying the substrate; depositing the anode layer on the surface of the substrate; overlapped depositing the hole injection layer, the hole transport layer, the emission layer, the electron transport layer and the electron injection layer sequentially on the surface of the anode layer; depositing the cathode layer on the surface of the electron injection layer to obtain the device.

## Description

### FIELD OF THE INVENTION

The present invention relates to the field of optoelectronic devices, and particularly relates to a top-emitting flexible organic light emission diode device. The present invention also relates to a method for preparing the top-emitting flexible organic light emission diode device.

### BACKGROUND OF THE INVENTION

Organic light emission diode device (also known as Organic Light Emission Diode, hereinafter referred to as OLED), has characteristics such as high luminance, wide selection of material, low driving voltage and solid-state self-luminosity, as well as advantages such as high definition, wide viewing angle, smooth motion display and fast response. OLED can be made into flexible structure, and can be folded and bent, such OLED is a kind of potential flat-panel display and flat light source, it not only conforms to the development trends of mobile communication and information display in the information age, but also meets the requirements of green lighting technology. It has become a hot research field in recent years.

Organic light emission diode device has a structure similar to sandwich, comprising cathode and anode positioned separately on the top and the bottom, and monolayer or multilayer functional layer(s) of organic materials sandwiched between the electrodes. The functional layers of organic materials have different materials and different structures. The functional layers are, in order, hole injection layer, hole transport layer, emission layer, electron transport layer and electron injection layer. Organic light emission diode device is carrier injection-type light emitting device. Once supplying working voltage to anode and cathode, hole from the anode and electrons from the cathode will inject into organic material layer of the device, and form hole-electron pairs, then light emits from one side of the electrodes.

However, most of the structures of current OLED are the type of bottom emission, the light transmittance of OLED is relatively low. Metal Ag is generally used as cathode material, better transmittance can be obtained when thin Ag is employed. Nevertheless, work function of Ag is 4.6 eV, there is relatively high barrier between it and LUMO energy level of normal electron transport materials. In addition, thick Ag will lead to relatively low light transmittance of Ag layer.

### SUMMARY OF THE INVENTION

The purpose of the present invention is to provide a top-emitting flexible organic light emission diode device having a high visible transmittance.

A top-emitting flexible organic light emission diode device including a substrate, an anode layer, a hole injection layer, a hole transport layer, an emission layer, an electron transport layer, an electron injection layer and a cathode layer stacked in sequence, wherein material of the cathode is samarium-silver alloy or ytterbium-silver alloy.

In the top-emitting flexible organic light emission diode device of the present invention, material of the substrate is polymer thin film, such as polyethylene terephthalate (PET), polyether sulfone (PES), polyethylene naphthalate (PEN), transparent polyimide (PI) or polycarbonate (PC).

Regarding the materials of cathode layer of said top-emitting flexible organic light emission diode device, when samarium-silver alloy is employed, mass ratio of samarium to silver is in the range of 1:10-1:1; or when ytterbium-silver alloy is employed, mass ratio of ytterbium to silver is in the range of 1:10-1:1.

In order to improve light emitting efficiency of cathode layer, an antireflection film covers the surface of cathode layer. Material of the antireflection film comprises tris(8-hydroxyquinolinato)aluminium (Alq₃), zinc selenide (ZnSe), zinc sulfide (ZnS), 2,9-dimethyl-4,7-diphenyl-1,10-phenanthroline (BCP) and 4,4',4"-tris(N-3-methylphenyl-N-phenylamino)triphenylamine (m-MTDATA).

Material of hole injection layer, hole transport layer, emission layer, electron transport layer and electron injection layer of the top-emitting flexible organic light emission diode device is commonly used in the art, such as:

Material of hole injection layer is selected from the group consisting of 4,4',4'-tris(N-3-methylphenyl-N-phenyl-amino)- triphenylamine (m-MTDATA) and copper phthalocyanine (CuPc);

Material of hole-transport layer is selected from the group consisting of N,N'-di-[(1-naphthalenyl)-N,N'-diphenyl]- (4.4'-biphenyl)- 4,4'- diamine (NPB), N,N'-bis(3-methylphenyl)-N,N'-diphenyl-benzidine (TPD) and 4,4',4"-tris(carbazol-9-yl)-triphenylamine (TCTA);

Material of emission layer is selected from Alq₃: C545T (wherein, C545T (1H,5H,11H-[1]benzopyrano[6,7,8-ij]quinolizin-11-one) is guest material, Alq₃ (tris(8-hydroxyquinolinato)aluminium) is host material, doping mass percentage of the guest material is 2%), FIrpic: CBP (wherein, FIrpic (bis(4,6-difluorophenylpyridinato-N,C2)picolinatoiridium) is guest material, CBP (4,4'-bis (N-carbazolyl)-1,1'-biphenyl) is host material, doping mass percentage of the guest material is 8%), TPBi:Ir(ppy)₃ (wherein, Ir(ppy)₃ (tris(2-phenylpyridine)iridium) is guest material, TPBi (1,3,5-tris(1-phenyl-1H-benzimidazol-2-yl)benzene) is host material, doping mass percentage of the guest material is 4%), DPVBi (4,4'-bis(2,2-diphenyl vinyl)-1,1'-biphenyl) and composite layer consisting of DPVBi and Rubrene (i.e. DPVBi/Rubrene).

Material of electron transport layer is selected from the group consisting of tris(8-hydroxyquinolinato)aluminium (Alq₃), 4,7-diphenyl-1,10-phenanthroline (Bphen) and 1,3,5-tris(1-phenyl-1H-benzimidazol-2-yl)benzene (TPBi);

Material of electron injection layer is selected from the group consisting of LiF, CsF and Li₂O.

Material of said anode layer is selected from Ag, Al, Au and other metals.

The present invention also provides a method for preparing the top-emitting flexible organic light emission diode device, which comprises the following steps:

S1, washing and drying substrate;

S2, vapor depositing an anode layer on the surface of said substrate by vacuum coating method;

S3, vapor depositing stacked hole injection layer, hole transport layer, emission layer, electron transport layer and electron injection layer on the surface of the anode layer in sequence by vacuum coating method;

S4, vapor depositing cathode layer on the surface of said electron injection layer, wherein, material of the cathode layer is samarium-silver alloy or ytterbium-silver alloy;

obtaining said top-emitting flexible organic light emission diode device after completion of the above process.

In the top-emitting flexible organic light emission diode device provided in the present invention, due to the samarium-silver alloy or ytterbium-silver alloy used as cathode layer, light extraction efficiency at the surface of cathode layer is improved to the range of 65-75%; accordingly, luminous efficiency is improved from 8.6 lm/W to the range of 12.2-15.5 1m/W.

### BRIEF DESCRIPTION OF THE DRAWINGS

Fig. 1 is a structural view of the top-emitting flexible organic light emission diode device of the present invention; wherein,
101 substrate, 102 anode layer, 103 hole injection layer, 104 hole transport layer, 105 emission layer, 106 electron transport layer, 107 electron injection layer, 108 cathode layer, 109 antireflection film;
Fig. 2 is a flow diagram showing the preparation of top-emitting flexible organic light emission diode device of the present invention;
Fig. 3 shows comparison of transmittance of Sm-Ag alloy cathode, Yb-Ag alloy cathode of the present invention with Ag cathode;
Fig. 4 shows current density-voltage curves of the top-emitting flexible organic light emission diode device prepared in Example 1 and Comparative Example 1;
Fig. 5 shows current density-voltage curves of the top-emitting flexible organic light emission diode device prepared in Example 4 and Comparative Example 2.

### DETAILED DESCRIPTION OF ILLUSTRATED EMBODIMENTS

Material of cathode commonly used for top-emitting organic light emission diode device generally comprises metal Ag or Al. Metal Ag has excellent conductivity, and has good transmittance when it is thin. However, work function of Ag is 4.6 eV, there is relatively high barrier between it and LUMO energy level of normal electron transport materials. In addition, thick Ag will lead to relatively low light transmittance of Ag layer.

Samarium (Sm) is rare earth metal material having a melting point of 1072°C, atomic radius of 2.59 Å. Ytterbium (Yb) has a melting point of 824.0°C, atomic radius of 2.4 Å. Such two kinds of metal material can easily form films by vacuum coating method. Furthermore, when Sm and Yb whose work function is respectively 2.7eV and 2.6eV are used as cathode of OLED, the injection barrier is much lower, compared with metal Al or Ag. In addition, metal Sm has greater visible transmittance than metal Ag. When metal Ag alloyed with such two kinds of material is used as cathode, work function of metal cathode can be reduced while maintaining a high visible transmittance, thus it is suitable for preparing translucent cathode structure.

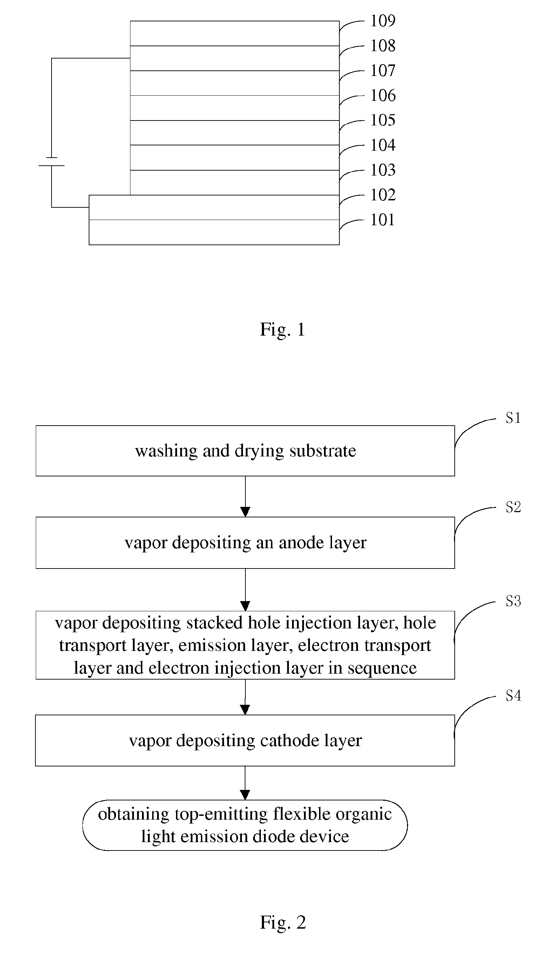

As shown in Fig. 1, the top-emitting flexible organic light emission diode device provided in the present invention includes substrate 101, anode layer 102, hole injection layer 103, hole transport layer 104, emission layer 105, electron transport layer 106, electron injection layer 107 and cathode layer 108 stacked in sequence, that is: substrate 101/anode layer 102/hole injection layer 103/hole transport layer 104/emission layer 105/electron transport layer 106/electron injection layer 107/cathode layer 108; wherein material of the cathode is samarium (Sm)-silver (Ag) alloy or ytterbium (Yb)-silver (Ag) alloy, i.e. Sm-Ag alloy or Yb-Ag alloy.

The top-emitting flexible organic light emission diode device preferably further includes an antireflection film 109, as shown in Fig. 1, the antireflection film 109 covers the cathode layer 108; material of the antireflection film 109 comprises tris(8-hydroxyquinolinato)aluminium (Alq₃), zinc selenide (ZnSe), zinc sulfide (ZnS), 2,9-dimethyl-4,7-diphenyl-1,10-phenanthroline (BCP) and 4,4',4"-tris(N-3-methylphenyl-N-phenylamino)triphenylamine (m-MTDATA).

Regarding the materials of cathode layer of said top-emitting flexible organic light emission diode device, when samarium-silver alloy is employed, mass ratio of samarium to silver is in the range of 1:10-1:1; or when ytterbium-silver alloy is employed, mass ratio of ytterbium to silver is in the range of 1:10-1:1. Because the top-emitting flexible organic light emission diode device is top-emitting OLED, so the thickness of said cathode is in the range of 15-30 nm, in addition, the cathode layer is translucent cathode layer, the visible light transmittance can be in the range of 65-75%.

In the top-emitting flexible organic light emission diode device, material of the substrate is polymer thin film, such as polyethylene terephthalate (PET), polyether sulfone (PES), polyethylene naphthalate (PEN), transparent polyimide (PI) or polycarbonate (PC); Given that the top-emitting flexible organic light emission diode device is a top-emitting OLED device, so the substrate material which is polymer film must be subjected to flat and hardening treatment to achieve a surface hardness of up to 2H-3H (pencil hardness).

Material of hole injection layer 103, hole transport layer 104, emission layer 105, electron transport layer 106 and electron injection layer 107 of the top-emitting flexible organic light emission diode device is commonly used in the art, such as:

Material of hole injection layer is selected from the group consisting of 4,4',4'-tris(N-3-methylphenyl-N-phenyl-amino)- triphenylamine (m-MTDATA) and copper phthalocyanine (CuPc);

Material of hole-transport layer is selected from the group consisting of N,N'-di-[(1-naphthalenyl)-N,N'-diphenyl]- (4.4'-biphenyl)- 4,4'- diamine (NPB), N,N'-bis(3-methylphenyl)-N,N'-diphenyl-benzidine (TPD) and 4,4',4"-tris(carbazol-9-yl)-triphenylamine (TCTA).

Material of emission layer is selected from Alq₃: C545T (wherein, C545T (1H,5H,11H-[1]benzopyrano[6,7,8-ij]quinolizin-11-one) is guest material, Alq₃ (tris(8-hydroxyquinolinato)aluminium) is host material, doping mass percentage of the guest material is 2%), FIrpic: CBP (wherein, FIrpic (bis(4,6-difluorophenylpyridinato-N,C2)picolinatoiridium) is guest material, CBP (4,4'-bis (N-carbazolyl)-1,1'-biphenyl) is host material, doping mass percentage of the guest material is 8%), TPBi:Ir(ppy)₃ (wherein, Ir(ppy)₃ (tris(2-phenylpyridine)iridium) is guest material, TPBi (1,3,5-tris(1-phenyl-1H-benzimidazol-2-yl)benzene) is host material, doping mass percentage of the guest material is 4%), DPVBi (4,4'-bis(2,2-diphenyl vinyl)-1,1'-biphenyl) and composite layer consisting of DPVBi and Rubrene (i.e. DPVBi/Rubrene).

Material of electron transport layer is selected from the group consisting of tris(8-hydroxyquinolinato)aluminium (Alq₃), 4,7-diphenyl-1,10-phenanthroline (Bphen) and 1,3,5-tris(1-phenyl-1H-benzimidazol-2-yl)benzene (TPBi);

Material of electron injection layer is selected from the group consisting of LiF, CsF and Li₂O.

Material of said anode layer is selected from metal Ag, Al and Au. Thickness of said anode layer is in the range of 18-100 nm.

The present invention also provides a method for preparing the top-emitting flexible organic light emission diode device, as shown in Fig. 2, which comprises the following steps:

S1. placing substrate (e.g. polymer film) into deionized water containing detergent for ultrasonic cleaning, washing with deionized water, ultrasonically treating successively with isopropanol and acetone, then blow drying with nitrogen for later use; wherein, polymer film comprises polyethylene terephthalate (PET), polyether sulfone (PES), polyethylene naphthalate (PEN), transparent polyimide (PI) and polycarbonate (PC);

S2, vapor depositing an anode layer on the surface of the cleaned and dried substrate by vacuum coating method, thickness of the anode layer is in the range of 18-100 nm;

S3, vapor depositing stacked hole injection layer, hole transport layer, emission layer, electron transport layer and electron injection layer on the surface of anode layer in sequence by vacuum coating method; thicknesses of said hole injection layer, hole transport layer, emission layer, electron transport layer and electron injection layer are in the range of, in order, 30-40 nm, 20-50 nm, 15-20 nm, 30-40 nm and 1 nm;

S4, vapor depositing a cathode layer of 18-30 nm thick on the surface of said electron injection layer, wherein, material of the cathode layer is samarium-silver alloy or ytterbium-silver alloy;

obtaining said top-emitting flexible organic light emission diode device after completion of the above process.

In the top-emitting flexible organic light emission diode device provided in the present invention, due to the samarium-silver alloy or ytterbium-silver alloy used as cathode layer, light extraction efficiency at the surface of cathode layer is improved to the range of 65-75%; accordingly, luminous efficiency is improved from 8.6 lm/W to the range of 12.2-15.5 1m/W.

Further description of the present invention will be illustrated, which combined with preferred embodiments and the drawings.

### Example 1

The top-emitting flexible organic light emission diode device of the Example 1 has a structure of PET/Ag/m-MTDATA/NPB/ C545T:Alq₃/ Alq₃/LiF/Sm-Ag/ Alq₃.

The method for preparing the top-emitting flexible organic light emission diode device is as follows.

PET film substrate was placed into deionized water containing detergent for ultrasonic cleaning, ultrasonically treated successively with isopropanol and acetone for 20 min, then blow dried with nitrogen.

In vacuum coating system, Ag of 18 nm thick was deposited on the surface of PET film to serve as anode. The anode was treated with oxygen plasma for 2 min.

After the processing, the following layers were deposited in sequence on anode: hole injection layer of m-MTDATA having a thickness of 30 nm, hole transport layer of NPB having a thickness of 50 nm, emission layer of Alq₃: C545T (wherein, C545T is guest material, Alq₃ is host material; doping mass percentage of the guest material was 2%) having a thickness of 20 nm, electron transport layer of Alq₃ having a thickness of 40 nm, electron injection layer of LiF having a thickness of 1 nm, and cathode layer of Sm-Ag alloy having a thickness of 18 nm, the mass ratio of Sm to Ag was 1:1. An antireflection film of Alq₃ having a thickness of 80 nm covered the surface of cathode.

### Example 2

The top-emitting flexible organic light emission diode device of the Example 2 has a structure of PES /Al/ CuPc/ NPB/ DPVBi/ Bphen/CsF/Sm-Ag/ZnS.

The method for preparing the top-emitting flexible organic light emission diode device is as follows.

PES film substrate was placed into deionized water containing detergent for ultrasonic cleaning, ultrasonically treated successively with isopropanol and acetone for 20 min, then blow dried with nitrogen.

In vacuum coating system, Al of 80 nm thick was deposited on the surface of PES film to serve as anode. The anode was treated with oxygen plasma for 5 min.

After the processing, the following layers were deposited in sequence on anode: hole injection layer of CuPc having a thickness of 30 nm, hole transport layer of NPB having a thickness of 40 nm, emission layer of DPVBi having a thickness of 20 nm, electron transport layer of Bphen having a thickness of 40 nm, electron injection layer of CsF having a thickness of 1 nm, and cathode layer of Sm-Ag alloy having a thickness of 25 nm, the mass ratio of Sm to Ag was 1:5. An antireflection film of ZnS having a thickness of 50 nm covered the surface of cathode.

### Example 3

The top-emitting flexible organic light emission diode device of the Example 3 has a structure of PI/Al/m-MTDATA/ TCTA/ FIrpic: CBP/ Bphen/Li₂O/Sm-Ag/ BCP.

The method for preparing the top-emitting flexible organic light emission diode device is as follows.

PI film substrate was placed into deionized water containing detergent for ultrasonic cleaning, ultrasonically treated successively with isopropanol and acetone for 20 min, then blow dried with nitrogen.

In vacuum coating system, Al of 100 nm thick was deposited on the surface of PEN film to serve as anode. The anode was treated with oxygen plasma for 15 min.

After the processing, the following layers were deposited in sequence on anode: hole injection layer of m-MTDATA having a thickness of 30 nm, hole transport layer of TCTA having a thickness of 40 nm, emission layer of FIrpic: CBP (wherein, FIrpic (bis(4,6-difluorophenylpyridinato-N,C2)picolinatoiridium) is guest material, CBP (4,4'-bis(N-carbazolyl)-1,1'-biphenyl) is host material; doping mass percentage of the guest material was 8%) having a thickness of 20 nm, electron transport layer of Bphen having a thickness of 40 nm, electron injection layer of Li₂O having a thickness of 1 nm, and cathode layer of Sm-Ag alloy having a thickness of 30 nm, the mass ratio of Sm to Ag was 1:1. An antireflection film of BCP having a thickness of 80 nm covered the surface of cathode.

### Example 4

The top-emitting flexible organic light emission diode device of the Example 4 has a structure of PEN/Ag/ m-MTDATA/NPB/ TPBi:Ir(ppy)₃/TPBi/LiF/Yb-Ag/ m-MTDATA.

The method for preparing the top-emitting flexible organic light emission diode device is as follows.

PEN film substrate was placed into deionized water containing detergent for ultrasonic cleaning, ultrasonically treated successively with isopropanol and acetone for 20 min, then blow dried with nitrogen.

In vacuum coating system, Ag of 80 nm thick was deposited on the surface of PEN film to serve as anode. The anode was treated with oxygen plasma for 2 min.

After the processing, the following layers were deposited in sequence on anode: hole injection layer of m-MTDATA having a thickness of 30 nm, hole transport layer of NPB having a thickness of 50 nm, emission layer of TPBi: Ir(ppy)₃ (wherein, Ir(ppy)₃ (tris(2-phenylpyridine)iridium) was guest material, TPBi (1,3,5-tris(1-phenyl-1H-benzimidazol-2-yl)benzene) was host material; doping mass percentage of the guest material was 4%) having a thickness of 20 nm, electron transport layer of TPBi having a thickness of 20 nm, electron injection layer of LiF having a thickness of 1 nm, and cathode layer of Yb-Ag alloy having a thickness of 30 nm, the mass ratio of Yb to Ag was 1:10. An antireflection film of m-MTDATA having a thickness of 80 nm covered the surface of cathode.

### Example 5

The top-emitting flexible organic light emission diode device of the Example 5 has a structure of PC /Au/ m-MTDATA/ NPB/ (DPVBi/Rubrene)/ Alq₃/LiF/Yb-Ag/ ZnSe.

The method for preparing the top-emitting flexible organic light emission diode device is as follows.

PC film substrate was placed into deionized water containing detergent for ultrasonic cleaning, ultrasonically treated successively with isopropanol and acetone for 20 min, then blow dried with nitrogen.

In vacuum coating system, Au of 30 nm thick was deposited on the surface of PC film to serve as anode. The anode was treated with oxygen plasma for 2 min.

After the processing, the following layers were deposited in sequence on anode: hole injection layer of m-MTDATA having a thickness of 30 nm, hole transport layer of NPB having a thickness of 50 nm, emission layer of DPVBi having a thickness of 20 nm, emission layer of Rubrene having a thickness of 0.2 nm (structure of emission layer was DPVBi/Rubrene), electron transport layer of Alq₃ having a thickness of 20 nm, electron injection layer of LiF having a thickness of 1 nm, and cathode layer of Yb-Ag alloy having a thickness of 25 nm, the mass ratio of Sm to Ag was 1:1. An antireflection film of ZnSe having a thickness of 50 nm covered the surface of cathode. The device can be made into a OLED which emits light from both sides.

### Comparative Example 1

The organic light emission diode device of the Comparative Example 1 has a structure of PET/Ag/m-MTDATA/NPB/ C545T:Alq₃/ Alq₃/LiF/ZnS.

The method for preparing the organic light emission diode device is as follows.

PET film substrate was placed into deionized water containing detergent for ultrasonic cleaning, ultrasonically treated successively with isopropanol and acetone for 20 min, then blow dried with nitrogen.

In vacuum coating system, Ag of 18 nm thick was deposited on the surface of PET film to serve as anode. The anode was treated with oxygen plasma for 2 min.

After the processing, the following layers were deposited in sequence on anode: hole injection layer of m-MTDATA having a thickness of 30 nm, hole transport layer of NPB having a thickness of 50 nm, emission layer of C545T:Alq₃ having a thickness of 20 nm, electron transport layer of Alq₃ having a thickness of 40 nm, electron injection layer of LiF having a thickness of 1 nm, and cathode layer of ZnS having a thickness of 45 nm.

### Comparative Example 2

The organic light emission diode device of the Comparative Example 1 has a structure of PEN/Ag/m-MTDATA/ NPB/TPBi:Ir(PPy)₃ /TPBi/LiF/Ag/m-MTDATA.

The method for preparing the organic light emission diode device is as follows.

PEN film substrate was placed into deionized water containing detergent for ultrasonic cleaning, ultrasonically treated successively with isopropanol and acetone for 20 min, then blow dried with nitrogen.

In vacuum coating system, Ag of 80 nm thick was deposited on the surface of PEN film to serve as anode. The anode was treated with oxygen plasma for 2 min.

After the processing, the following layers were deposited in sequence on anode: hole injection layer of m-MTDATA having a thickness of 30 nm, hole transport layer of NPB having a thickness of 50 nm, emission layer of TPBi:Ir(ppy)₃ (wherein, Ir(ppy)₃ (tris(2-phenylpyridine)iridium) was guest material, TPBi (1,3,5-tris(1-phenyl-1H-benzimidazol-2-yl)benzene) was host material; doping mass percentage of the guest material was 4%) having a thickness of 20 nm, electron transport layer of TPBi having a thickness of 20 nm, electron injection layer of LiF having a thickness of 1 nm, and cathode layer of Ag having a thickness of 20 nm.

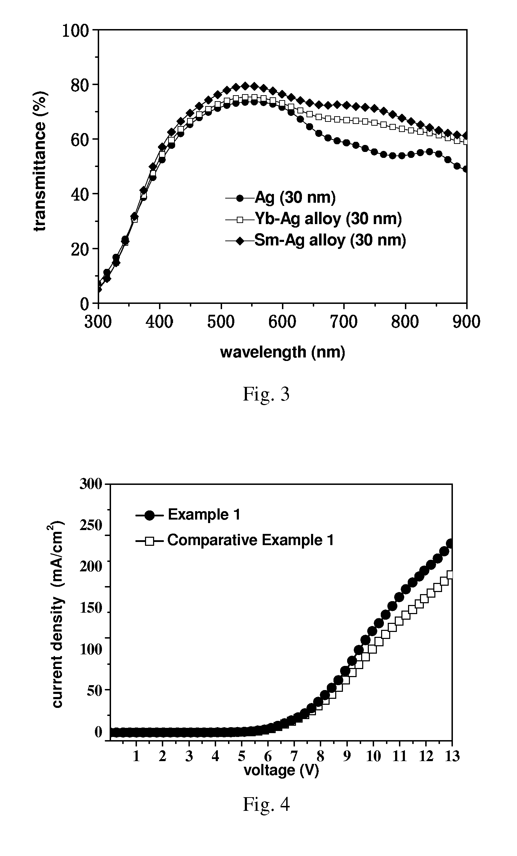

Fig. 3 shows comparison of transmittance of Sm-Ag alloy electrode having a thickness of 30 nm (mass ratio of Sm to Ag is 1:1, Example 3), Yb-Ag alloy electrode having a thickness of 30 nm (mass ratio of Yb to Ag is 1:10, Example 4) with Ag electrode having a thickness of 30 nm.

It can be seen from Fig. 3 that Sm-Ag and Yb-Ag alloy cathodes provided in the present invention have higher transmittance than Ag electrode. So the light extraction efficiency at the surface of cathode of top-emitting device can be improved.

Fig. 4 shows current density-voltage curves of the top-emitting flexible organic light emission diode devices prepared in Example 1 and Comparative Example 1.

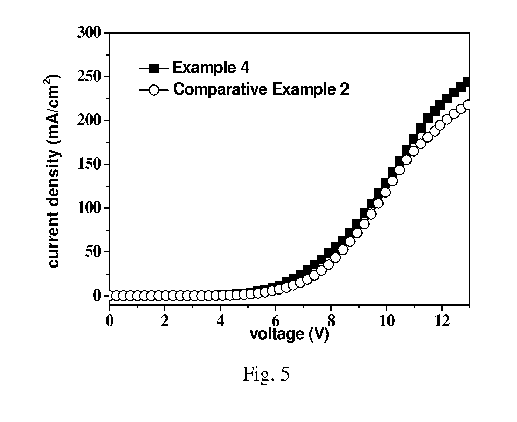

Fig. 5 shows current density-voltage curves of the top-emitting flexible organic light emission diode devices prepared in Example 4 and Comparative Example 2.

From Fig. 4 and Fig. 5 it can be seen that the Sm-Ag and Yb-Ag alloy cathode provided in the present invention have lower work function than Ag, so the present invention has better electron injection, resulting in a higher current density at the same driving voltage.

While the present invention has been described with reference to particular embodiments, it will be understood that the embodiments are illustrative and that the invention scope is not so limited. Alternative embodiments of the present invention will become apparent to those having ordinary skill in the art to which the present invention pertains. Such alternate embodiments are considered to be encompassed within the spirit and scope of the present invention. Accordingly, the scope of the present invention is described by the appended claims and is supported by the foregoing description.

## Claims

1. A top-emitting flexible organic light emission diode device including a substrate, an anode layer, a hole injection layer, a hole transport layer, an emission layer, an electron transport layer, an electron injection layer and a cathode layer stacked in sequence, wherein material of said cathode is samarium-silver alloy or ytterbium-silver alloy.

2. The top-emitting flexible organic light emission diode device according to claim 1, wherein in said samarium-silver alloy, mass ratio of samarium to silver is in the range of 1:10-1:1; in said ytterbium-silver alloy, mass ratio of ytterbium to silver is in the range of 1:10-1:1.

3. The top-emitting flexible organic light emission diode device according to claim 1 or 2, wherein further including an antireflection film on the surface of said cathode layer.

4. The top-emitting flexible organic light emission diode device according to claim 3, wherein material of said antireflection film is tris(8-hydroxyquinolinato) aluminium, zinc selenide, zinc sulfide, 2,9-dimethyl-4,7-diphenyl-1,10-phenanthroline or 4,4',4"-tris(N-3-methylphenyl-N-phenylamino)triphenylamine.

5. The top-emitting flexible organic light emission diode device according to claim 1, wherein material of said substrate is polyethylene terephthalate, polyether sulfone, polyethylene naphthalate, transparent polyimide or polycarbonate; material of said anode layer is silver, aluminium or gold.

6. A method for preparing top-emitting flexible organic light emission diode device, comprising:
S1, washing and drying substrate;
S2, vapor depositing an anode layer on the surface of said substrate;
S3, vapor depositing stacked hole injection layer, hole transport layer, emission layer, electron transport layer and electron injection layer on the surface of said anode layer in sequence;
S4, vapor depositing cathode layer on the surface of said electron injection layer, material of said cathode layer is samarium-silver alloy or ytterbium-silver alloy;
obtaining said top-emitting flexible organic light emission diode device after completion of the above process.

7. The method for preparing top-emitting flexible organic light emission diode device according to claim 6, wherein in said samarium-silver alloy, mass ratio of samarium to silver is in the range of 1:10-1:1; in said ytterbium-silver alloy, mass ratio of ytterbium to silver is in the range of 1:10-1:1.

8. The method for preparing top-emitting flexible organic light emission diode device according to claim 6 or 7, wherein further comprising the following step:
preparing a antireflection film on the surface of said cathode layer.

9. The method for preparing top-emitting flexible organic light emission diode device according to claim 8, wherein material of said antireflection film is tris(8-hydroxyquinolinato)aluminium, zinc selenide, zinc sulfide, 2,9-dimethyl-4,7-diphenyl- 1,10- phenanthroline or 4,4',4"-tris (N-3- methylphenyl-N- phenylamino) triphenylamine.

10. The method for preparing top-emitting flexible organic light emission diode device according to claim 6, wherein material of said substrate is polyethylene terephthalate, polyether sulfone, polyethylene naphthalate, transparent polyimide (PI) or polycarbonate; material of said anode layer is silver, aluminium or gold.
